(19) Europäisches Patentamt
European Patent Office
Office européen des brevets

(11) **EP 4 723 178 A1**

(12) **EUROPEAN PATENT APPLICATION**
published in accordance with Art. 153(4) EPC

(43) Date of publication:
**08.04.2026 Bulletin 2026/15**

(21) Application number: **24815486.6**

(22) Date of filing: **28.05.2024**

(51) International Patent Classification (IPC):
*H01L 33/46* (2010.01)        *G03F 7/20* (2006.01)
*H01L 33/32* (2010.01)

(52) Cooperative Patent Classification (CPC):
**G03F 7/20; H10H 20/819; H10H 20/825;
H10H 20/841**

(86) International application number:
**PCT/JP2024/019565**

(87) International publication number:
**WO 2024/248004 (05.12.2024 Gazette 2024/49)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **31.05.2023 JP 2023090283**

(71) Applicants:
• **Nitride Semiconductors Co., Ltd.
Naruto-shi,
Tokushima 771-0360 (JP)**

• **NIKON CORPORATION
Tokyo 140-8601 (JP)**

(72) Inventors:
• **MURAMOTO, Yoshihiko
Naruto-shi, Tokushima 771-0360 (JP)**
• **NISHINE, Tatsuro
Tokyo 1408601 (JP)**

(74) Representative: **Osha BWB
2, rue de la Paix
75002 Paris (FR)**

(54) **METHOD FOR MANUFACTURING GALLIUM NITRIDE LIGHT EMITTING ELEMENT, AND LIGHTING DEVICE**

(57)    The present invention provides a method for manufacturing a GaN light emitting element having adjustable directional characteristics. The method comprises: a step in which an n-type GaN layer (12), an MQW layer (14), and a p-type GaN layer (16) are epitaxially grown in sequence on a sapphire substrate (10) so as to form an epitaxial structure; a step in which a p-type electrode, a metal reflective film, a metal substrate, and a support substrate are formed on the p-type GaN layer (16); a step in which the epitaxial structure is inverted vertically; a step in which the sapphire substrate (10) is separated so as to expose the n-type GaN layer (12) in the surface; a step in which the n-type GaN layer (12) exposed in the surface is etched so as to adjust a resonator length between the surface of the metal reflective film and the surface of the n-type GaN layer (12); and a step in which an n-electrode (24) is formed.

FIG. 2

**Description**

TECHNICAL FIELD

The present invention relates to a method for manufacturing a gallium nitride light-emitting element and a lighting device.

BACKGROUND

In order to narrow the radiation angle of light emitted from a light-emitting element (LED) chip using gallium nitride (GaN), studies have been conducted on mounting a lens on the LED device to collect light.

However, in a case where a lens is mounted, if the radiation pattern is changed even slightly, it is necessary to change the mold, which increases cost. In addition, in a case where ultraviolet rays or deep ultraviolet rays are emitted, a quartz lens is used in consideration of lens absorption, which makes the lens expensive.

Therefore, as a method for narrowing the radiation pattern by condensing light without mounting a lens on an LED device, studies have been conducted on forming a photonic crystal on a surface of an LED chip with holes on the order of several hundred nanometers at a pitch of several hundred nanometers.

Patent Document 1 describes an invention related to a gallium nitride-based photonic crystal and a method for producing the same. That is, in order to provide a gallium nitride-based semiconductor element, a gallium nitride-based semiconductor substrate, and a gallium nitride-based photonic crystal with high performance at a high yield by obtaining a nitride semiconductor having good crystallinity in which the dislocation density is reduced in a wide region in epitaxial growth, the method is described to include: forming a gallium nitride-based semiconductor layer on a substrate; arranging and forming a plurality of trenches in the gallium nitride-based semiconductor layer; and performing a heat treatment in an atmosphere containing nitrogen to deform two or more trenches adjacent to each other among the plurality of trenches and form a continuous cavity inside the gallium nitride-based semiconductor layer corresponding to a position of the deformed trenches, and forming a gallium nitride-based semiconductor element on the gallium nitride-based semiconductor layer with the cavity therein.

In addition, in order to provide a photonic crystal light-emitting diode that is less likely to deteriorate over a long period of time, and has high energy efficiency and high luminous efficiency, Patent Document 2 discloses a photonic crystal light-emitting diode having a structure in which three layers, a first semiconductor layer, an active layer, and a second semiconductor layer, are stacked in this order, with a first electrode electrically connected to the first semiconductor layer and a second electrode electrically connected to the second semiconductor layer, in which holes penetrating at least the first semiconductor layer and the active layer among the three layers are arranged two-dimensionally and periodically so as to form a photonic crystal structure, and the first electrode covers a region of the first semiconductor layer excluding the holes and a first non-current injection region surrounding the holes.

CITATION LIST

PATENT LITERATURE

Patent Document 1: JP 2004-111766 A
Patent Document 2: JP 2011-54828 A

SUMMARY

TECHNICAL PROBLEM

However, in a case where a light-emitting element such as an LED is made of gallium nitride (GaN), the technology for adjusting its radiation pattern characteristics has not yet been established.

An object of the present invention is to provide a method for manufacturing a GaN light-emitting element whose radiation pattern characteristics can be adjusted.

SOLUTION TO PROBLEM

The present invention provides a method for manufacturing a gallium nitride light-emitting element, the method including: sequentially stacking a metal reflective film, a p-type gallium nitride layer, a multiple quantum well layer, and an n-type gallium nitride layer on a substrate; and adjusting a resonator length formed between a surface of the metal reflective film and a surface of the n-type gallium nitride layer to adjust a radiation pattern characteristic of emitted light.

In one embodiment of the present invention, in the adjusting of the resonator length, a film thickness d between the surface of the metal reflective film and the surface of the n-type gallium nitride layer is adjusted such that:

$$d = m \cdot \lambda / n$$

where n is a refractive index, $\lambda$ is a wavelength of the emitted light, and m is an integer.

In another embodiment of the present invention, the emitted light has a narrowed radiation pattern by setting m to have a small value.

Further, the present invention provides a method for manufacturing a gallium nitride light-emitting element, the method including: forming an epitaxial structure by epitaxially growing an n-type gallium nitride layer, a multiple quantum well layer, and a p-type gallium nitride layer sequentially on a sapphire substrate; forming a p-type electrode on the p-type gallium nitride layer; forming a metal reflective film, a metal substrate, and a support substrate on the p-type electrode; inverting the epitaxial structure upside down so that the support substrate is located at the bottom and the sapphire substrate is located at the top; exposing a surface of the n-type gallium nitride layer by peeling off the sapphire substrate located at the top by the inversion; etching the n-type gallium nitride layer to adjust a resonator length formed between a surface of the metal reflective film and a surface of the n-type gallium nitride layer; forming an n-type electrode on the n-type gallium nitride layer; and peeling off the support substrate.

In one embodiment of the present invention, in the etching of the n-type gallium nitride layer, the n-type gallium nitride layer is etched such that:

$$d = m \cdot \lambda / n$$

where d is a film thickness between the surface of the metal reflective film and the surface of the n-type gallium nitride layer, n is a refractive index, $\lambda$ is a wavelength of emitted light, and m is an integer.

In another embodiment of the present invention, the gallium nitride light-emitting element has an emission wavelength of 380 nm to 390 nm.

In addition, the present invention provides a lighting device including: the gallium nitride light-emitting element manufactured by the above-described method; and an illumination optical system that illuminates an object with light from the gallium nitride light-emitting element.

ADVANTAGEOUS EFFECTS OF INVENTION

According to the present invention, the radiation pattern characteristics of the GaN light-emitting element can be adjusted. In particular, by adjusting the film thickness in the process of manufacturing the GaN light-emitting element, the radiation pattern characteristics of emitted light can be adjusted.

BRIEF DESCRIPTION OF DRAWINGS

FIG. 1A is a schematic cross-sectional view (part 1) showing a manufacturing method according to an embodiment.
FIG. 1B is a schematic cross-sectional view (part 2) showing the manufacturing method according to the embodiment.
FIG. 1C is a schematic cross-sectional view (part 3) showing the manufacturing method according to the embodiment.
FIG. 1D is a schematic cross-sectional view (part 4) showing the manufacturing method according to the embodiment.
FIG. 1E is a schematic cross-sectional view (part 5) showing the manufacturing method according to the embodiment.
FIG. 1F is a schematic cross-sectional view (part 6) showing the manufacturing method according to the embodiment.
FIG. 1G is a schematic cross-sectional view (part 7) showing the manufacturing method according to the embodiment.
FIG. 1H is a schematic cross-sectional view (part 8) showing the manufacturing method according to the embodiment.
FIG. 1I is a schematic cross-sectional view (part 9) showing the manufacturing method according to the embodiment.
FIG. 2 is a schematic cross-sectional view of a GaN light-emitting element according to the embodiment.
FIG. 3 is a diagram showing a configuration of a lighting device and an exposure apparatus according to the embodiment.
FIG. 4 is a diagram showing a configuration of a light source unit.
FIG. 5 is a plan view showing positions of V chip samples in examples.
FIG. 6 is a table showing measurement results using an integrating sphere in examples.
FIG. 7 is a table showing emission spectra in the examples.
FIG. 8 is a diagram showing I-L characteristics in the examples.
FIG. 9 is a diagram showing I-V characteristics in the examples.
FIG. 10 is a diagram showing results of measuring radiation pattern characteristics of references in the examples.
FIG. 11 is a diagram showing results of measuring radiation pattern characteristics of GaN light-emitting elements whose film thicknesses have been adjusted in the examples.

DESCRIPTION OF EMBODIMENTS

Hereinafter, an embodiment of the present invention will be described with reference to the drawings.
Taking into account that the radiation pattern characteristic of light emitted from the GaN light-emitting element can be changed by adjusting the resonator length of the resonator structure included in the GaN stacked structure constituting the GaN light-emitting element, the basic principle of the present embodiment is to manufacture a GaN light-emitting element so as to adjust the resonator length and control the radiation pattern characteristic to a desired characteristic.
The inventors of the present application have found that, in a GaN stacked structure sequentially grown on a substrate, by adjusting a resonator length formed between a surface of a GaN layer and a surface of a metal reflective film below the surface of the GaN layer, specifically, by adjusting a film thickness of an n-type GaN layer or a p-type GaN layer constituting the resonator length, the radiation pattern characteristic of light emitted from a GaN light-emitting element can be changed. It has been found that the radiation pattern can be controlled by adjusting the resonator length, given that the resonator length is expressed as follows:

$$\text{resonator length} = m \cdot \lambda / n,$$

where $\lambda$ is an emission wavelength, $n$ is a refractive index, and $m$ is an integer ($m$=1, 2, 3,...).

In addition, the inventors of the present application have also found that the thinner the film thickness, the narrower the radiation pattern. This means that, in the above-described equation, the effect of narrowing the radiation pattern of light is higher as $m$ is set smaller.

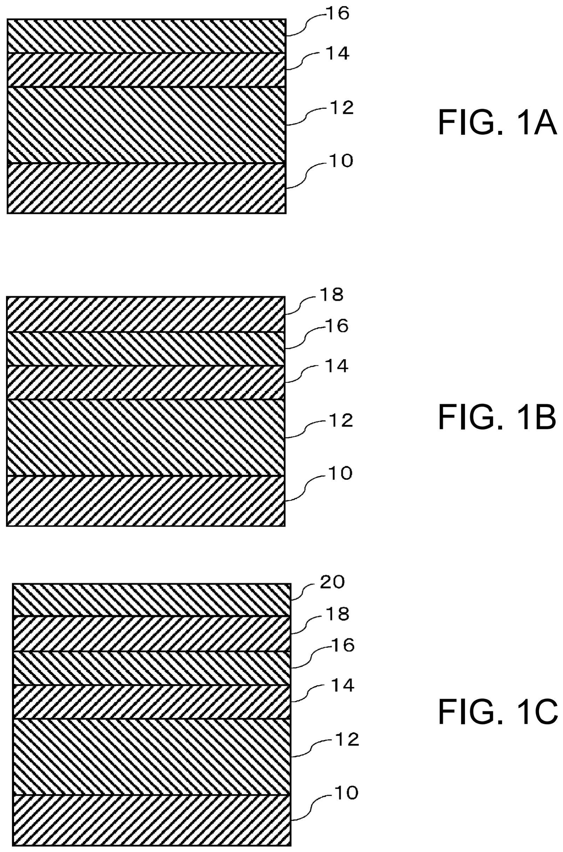

FIGS. 1A to 1I are cross-sectional views schematically showing a method for manufacturing a GaN light-emitting element (LED) according to the present embodiment.

As shown in FIG. 1A, a low-temperature buffer layer (not shown) and an undoped GaN (u-GaN) layer (not shown) are stacked on a sapphire substrate 10 using a metal organic chemical vapor deposition (MOCVD) apparatus, and an n-GaN layer (n-type GaN layer) 12, a multiple quantum well (MQW) layer 14, and a p-GaN layer (p-type GaN layer) 16 are sequentially stacked thereon to grow an epitaxial structure emitting light at 385 nm (380 to 390 nm).

Here, the n-GaN layer 12 is more specifically formed of an n-GaN contact layer, an (AlInGaN)/(In-GaN;Si) n-SLS (super-lattice structure) layer, and an (AlGaN;Si) layer. Here, for example, (GaN;Si) indicates GaN doped with Si.

The multiple quantum well (MQW) layer 14 is formed of a total of six MQW layers of (InGaN/AlGaN).

In addition, the p-GaN layer 16 is more specifically formed of a p-GaN(GaN;Mg) contact layer and an (AlGaN;Mg/GaN;Mg) p-SLS (super-lattice structure) layer.

The "GaN layer" in the present embodiment does not necessarily mean a single layer composed of GaN, but means a single layer or multiple layers composed of AlInGaN, InGaN, AlGaN, or the like containing GaN. In short, it means a single layer or multiple layers containing GaN as a main component.

Note that, although the emission wavelength of the epitaxial layer in the present embodiment is 385 nm, the emission wavelength of the epitaxial layer may be longer than 385 nm. In this case, the basic epitaxial structure is the same. However, from the relationship with bandgap energy, the (InGaN/AlInGaN) MQW light-emitting layer 14 has a higher Al content and a lower In content in a case where the emission wavelength of the epitaxial layer is 385 nm than in a case where the emission wavelength of the epitaxial layer is longer than 385 nm.

Next, as shown in FIG. 1B, a p-electrode (p-type electrode: ITO or the like) and a metal reflective film (Ag or the like) are deposited on the epitaxial structure layer that emits light at 385 nm. In FIG. 1B, the p-electrode and the metal reflective film are collectively shown as a p-electrode and reflection film 18.

Next, as shown in FIG. 1C, a metal substrate (CuW, CuMo, or the like) 20 is bonded onto the p-electrode and metal reflective film 18.

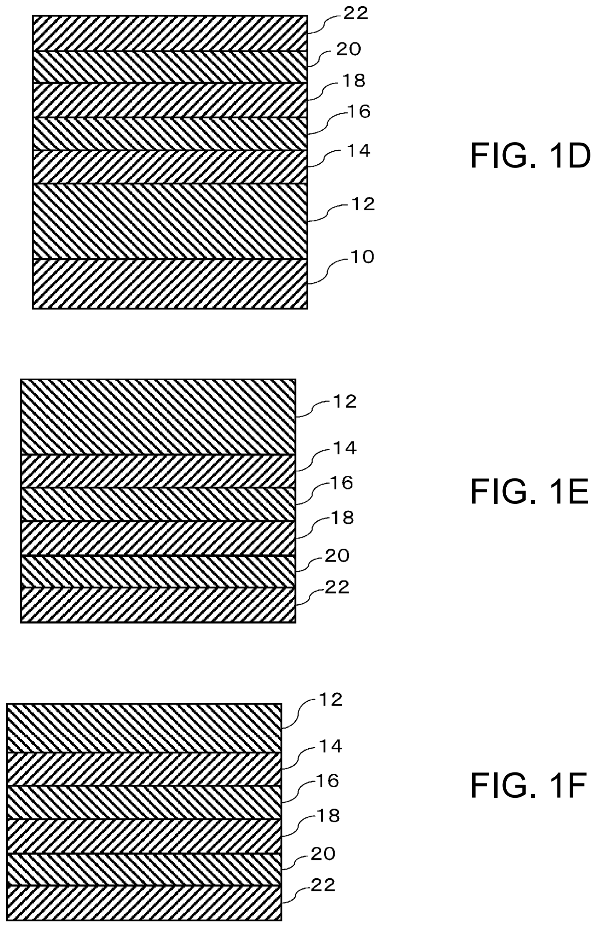

Next, as shown in FIG. 1D, a support substrate (sapphire, Si substrate, or the like) 22 is bonded onto the metal substrate 20. The stacked structure shown in FIG. 1D includes in the following order from the bottom: sapphire substrate 10/ n-GaN layer 12/ MQW layer 14/ p-GaN layer 16/ p-electrode and reflection film 18/ metal substrate 20/ support substrate 22.

Next, as shown in FIG. 1E, the epitaxial structure of FIG. 1D is inverted upside down by 180° so that the sapphire substrate 10 is located at the top, and the sapphire substrate 10 is peeled off (lifted off) using a laser to expose a surface of the n-GaN layer 12. That is, the stacked structure obtained by vertically inverting the epitaxial structure of FIG. 1D by 180° includes in the following order from the bottom: support substrate 22/ metal substrate 20/ p-electrode and reflection film 18/ p-GaN layer 16/ MQW layer 14/ n-GaN layer 12/ sapphire substrate 10.

Among them, the uppermost sapphire substrate 10 (and the buffer layer) is peeled off (lifted off) to expose the uppermost surface of the n-GaN layer 12.

Next, as shown in FIG. 1F, the film thickness is adjusted by etching the surface of the n-GaN layer 12. By etching the n-GaN layer 12, the total film thickness from the n-GaN layer 12 to the p-GaN layer 16 is adjusted to a predetermined film thickness.

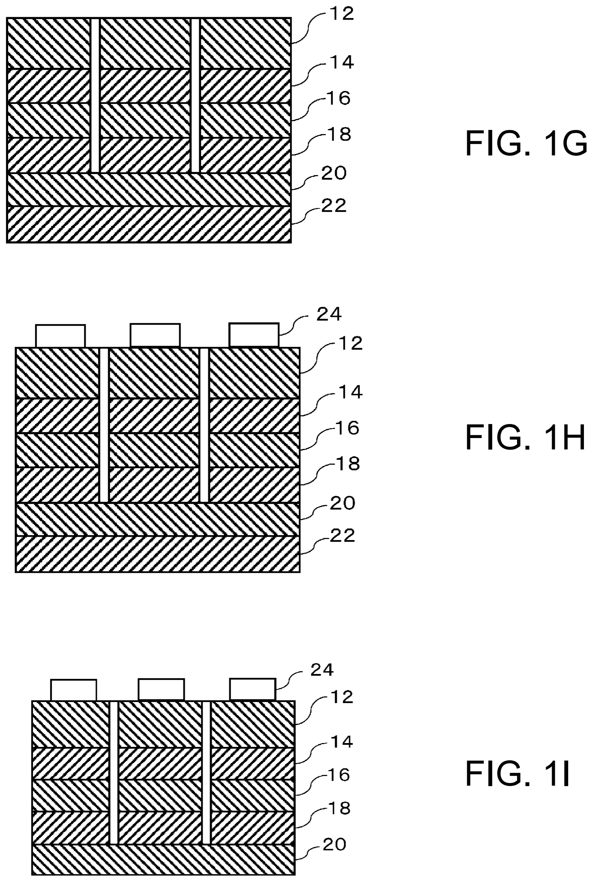

Next, as shown in FIG. 1G, trenches are formed from the surface of the n-GaN layer 12 until reaching the metal substrate 20 to divide the epitaxial structure.

Next, as shown in FIG. 1H, an n-electrode (n-type electrode) 24 is formed in each divided region on the n-GaN layer 12.

Lastly, as shown in FIG. 1I, the support substrate 22 is peeled off, and diced to manufacture LED chips (V-chip structure LED chips: vertical-type LED chips in which electrodes are arranged in a vertical structure).

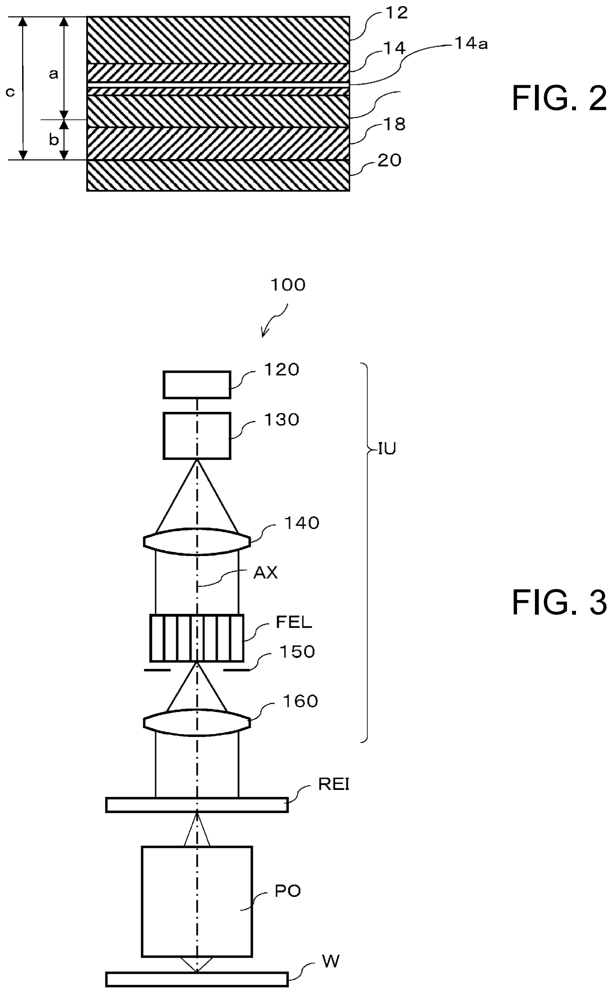

FIG. 2 shows a schematic cross-sectional view of a GaN light-emitting element having a V-chip structure manufactured as described above and an example of a film thickness thereof. In the drawing:

a: a film thickness from the surface of the n-GaN layer 12 to the film thickness of the lowest quantum well layer 14a, among quantum well layers and quantum barrier layers constituting the MQW layer 14 = 1149.23 nm;

b: a film thickness from the surface of the lowest quantum barrier layer (the interface between the quantum barrier layer and the quantum well layer 14a) among quantum well layers and quantum barrier layers constituting the MQW layer 14 to the film thickness of the p-GaN layer 16 = 152.56 nm; and c: the sum of a and b = 1301.79 nm.

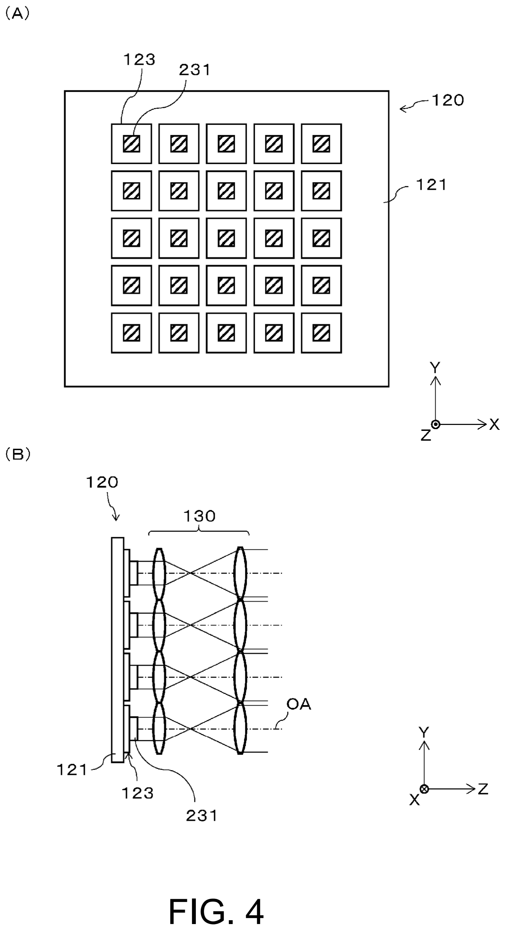

Next, a lighting device including a GaN light-emitting element manufactured by the manufacturing method according to the above-described embodiment and an exposure apparatus including the lighting device will be described with reference to FIGS. 3 and 4.

FIG. 3 is a diagram schematically showing a configuration of an exposure apparatus including a lighting device IU using a GaN light-emitting element manufactured by the manufacturing method according to the above-described embodiment as a light source. FIG. 4(A) is a plan view schematically showing a configuration of a light source unit 120 that supplies exposure light to the lighting device IU, and FIG. 4(B) is a view schematically showing an internal configuration of the light source unit 120 and an output optical system 130.

In FIG. 3, the lighting device IU includes a first condensing optical system 140 that condenses exposure light from the light source unit 120 via the output optical system 130, a fly-eye lens FEL on which the exposure light from the first condensing optical system 140 is incident, and a second condensing optical system 160 that condenses the exposure light from the fly-eye lens FEL and illuminates a reticle REI as an irradiated surface.

The exposure apparatus includes a lighting device IU and a projection optical system PO that forms a pattern image on the reticle illuminated by the lighting device IU onto a wafer as an exposed substrate.

Next, the light source unit 120 and the output optical system 130 will be described with reference to FIG. 4.

In FIG. 4(A), the light source unit 120 includes, for example, a plurality of (5×5 in FIG. 3(A)) light-emitting diode (LED) chips 123 arranged on a substrate 121. These LED chips are GaN light-emitting elements manufactured by the manufacturing method according to the above-described embodiment. Note that the number of LED chips 123 may be appropriately changed as necessary. Each of the plurality of LED chips 123 has a light-emitting unit 231, and a peak wavelength of light emitted from the light-emitting unit 231 is in a range of 380 to 390 nm. That is, the light-emitting unit 231 is an ultraviolet LED (UVLED). More preferably, the peak wavelength of the light emitted from the light-emitting unit 231 is 385 nm. The light-emitting surface of the light-emitting unit 231 may have a square shape, a rectangular shape, or any other polygonal shape such as a hexagonal shape. Note that the LED chips 123 may be arranged on, for example, a heat sink instead of the substrate.

The configurations of the light source unit 120 and the output optical system 130 will be described with reference to FIG. 4(B). In FIG. 3(B), two directions in which the LED chips 123 are arranged are defined as an X direction and a Y direction. The X direction and the Y direction are orthogonal to each other. A direction orthogonal to the X direction and the Y direction is defined as a Z direction. The Z direction substantially coincides with a traveling direction of light emitted from the light-emitting unit 231. In FIG. 4(B), for the sake of clarity in the drawing, only four LED chips 123 arranged in a row along the Y direction are shown.

As shown in FIG. 4(B), the output optical system 130 includes a plurality of magnifying optical systems for forming magnified images of the light-emitting units 231 of the respective LED chips 123. The magnifying optical systems are arranged so as to correspond to the arrangement of the LED chips 123, and are double-telecentric optical systems that project the respective light-emitting units 231 in an enlarged manner at an enlargement magnification. Note that, although it is shown in FIG. 4(B) that each magnifying optical system of the output optical system 130 is constituted by two positive lenses, the number of lenses constituting the magnifying optical system is not limited to two. In addition, the magnifying optical system may also be constituted by a catoptric system or a catadioptric system. Then, the output optical system 130 may include equal magnification optical systems and reduction optical systems instead of or in addition to the magnifying optical systems.

In the embodiment shown in FIGS. 3 and 4, each magnifying optical system of the output optical system 130 forms a magnified image of the light-emitting unit 231 in the vicinity of the last optical member of the output optical system 130. As a result, a plurality of closely arranged light source images are positioned in the vicinity of the last optical member of the output optical system 130.

Returning to FIG. 3, each component of the lighting device IU will be described.

The first condensing optical system 140 is disposed such that the front focal point is located at or near the position of the light source image formed by the light source unit 120 and the output optical system 130, and performs Köhler illumination on the incident surface of the fly-eye lens FEL.

The fly-eye lens FEL is configured by, for example, arranging a plurality of lens elements having positive refractive power densely in rows and columns such that their optical axes are parallel to a reference optical axis AX. Each lens element constituting the fly-eye lens FEL has a rectangular cross section similar to the shape of the illumination field to be formed on the reticle REI (eventually, the shape of the exposure region to be formed on the wafer W).

Therefore, the light flux incident on the fly-eye lens FEL is wavefront-split by the plurality of lens elements, and one light source image is formed at or near the rear focal plane (emission surface) of each lens element. That is, a substantial surface light source including a plurality of light source images; that is, a secondary light source, is formed on or near the rear focal plane (emission surface) of the fly-eye lens FEL.

Here, focusing on one lens element of the fly-eye lens FEL, a plurality of light source images formed by the light source unit 120 and the output optical system 130 are formed on or near the rear focal plane (emission surface) of this one lens element, and the plurality of light source images are distributed in a region having a shape similar to a region where the plurality of LED chips 123 are arranged. Therefore, the region where the plurality of LED chips 123 are arranged and the cross section of each lens element of the fly-eye lens FEL may have similar shapes.

The light flux from the secondary light source formed on or near the rear focal plane (emission surface) of the fly-eye lens FEL is incident on an aperture stop 150 disposed near the rear focal plane. In the present embodiment, the rear focal plane (emission surface) of the fly-eye lens FEL and the LED chip arrangement surface of the light source unit 120 are optically conjugate.

The aperture stop 150 is disposed at a position optically substantially conjugate with the entrance pupil plane of the projection optical system PO, and has a variable aperture for defining a range contributing to the illumination of the secondary light source. After being subjected to a light condensing action of the second condensing optical system 160, exposure light from the secondary light source via the aperture stop 150 illuminates the reticle REI on which the predetermined pattern is formed in a superimposed manner.

Then, the exposure light from the reticle REI illuminated by the lighting device IU (the exposure light passing through the pattern located in the illumination field on the reticle REI) is incident on the projection optical system PO, and forms a pattern image of the reticle REI on the wafer W as an exposed substrate. As a result, the pattern of the reticle REI is exposed to the exposure region of the wafer W. Note that the projection magnification of the projection optical system PO may be a reduction magnification, an enlargement magnification, or an equal magnification. Further, the projection optical system PO may be a dioptric system, a catoptric system, or a catadioptric system.

EXAMPLES

A GaN light-emitting element was manufactured on a wafer according to the above-described manufacturing method.

After growing the epitaxial structure, the film thicknesses of the p-GaN layer 16 and the last quantum barrier layer of the MQW layer 14 were measured by cross-sectional TEM observation, and the growth rate was calculated from the results of measuring the film thicknesses.

Thereafter, the growth time of the p-GaN layer 16 was adjusted based on the calculated growth rate, thereby adjusting the film thickness from the last barrier layer of the MQW layer 14 to the P-GaN layer 12 to a predetermined film thickness.

The film thickness of each layer was as follows.

n-GaN layer 12: 1098.77 nm
MQW layer 14 (six pairs of quantum well layers and quantum barrier layers): 50.46 nm
Last quantum barrier layer: 30.21 nm
p-GaN layer 14: 122.35 nm

In addition, as a comparative example (reference), a GaN light-emitting element whose film thickness was not adjusted was manufactured on a wafer. In the reference, both the n-GaN layer 12 and the p-GaN layer 14 are set to be thicker than those in a GaN light-emitting element according to an example.

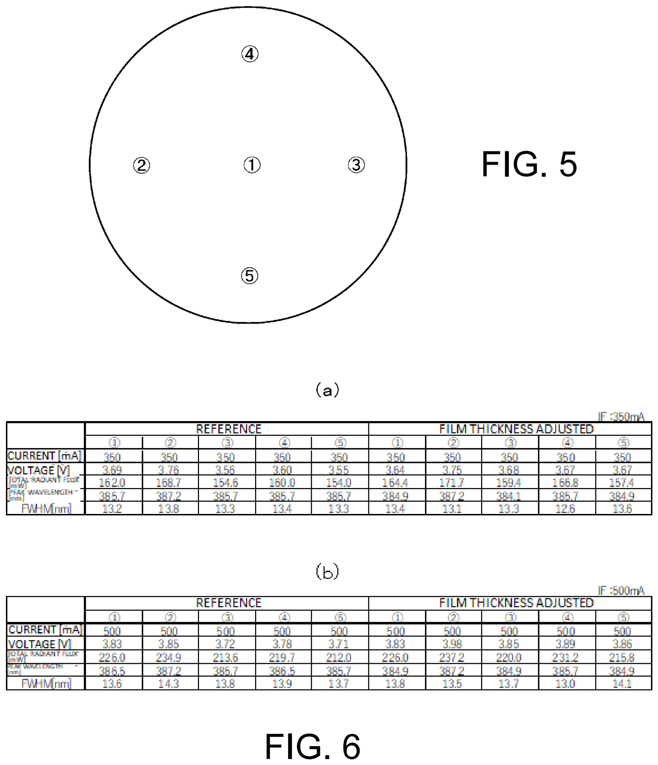

FIG. 5 shows a plan view of a GaN wafer according to an example. In FIG. 5, reference V chips (whose film thicknesses were not adjusted) and V chips whose film thicknesses had been adjusted were taken out at a total of five positions indicated by circled numbers 1 to 5 and mounted on an Al substrate, and their electrical characteristics, optical outputs, and wavelengths were measured using an integrating sphere.

As a result of observing the appearances of the reference V chips (whose film thicknesses were not adjusted) and the V chips whose film thicknesses had been adjusted, there was no difference in surface state.

FIG. 6 shows results of measuring the electrical characteristics of the reference V chips (whose film thicknesses were not adjusted) and the V chips whose film thicknesses had been adjusted using an integrating sphere. FIG. 6(a) shows currents, voltages, total radiant fluxes, peak wavelengths, and FWHMs (full width at half maximum) as electrical characteristics of the reference V chips (whose film thicknesses were not adjusted) and the V chips whose film thicknesses had been adjusted at IF (forward current) = 350 mA. In addition, FIG. 6(b) shows currents, voltages, total radiant fluxes, peak wavelengths, and FWHMs as electrical characteristics of the reference V chips (whose film thicknesses were not adjusted) and the V chips whose film thicknesses had been adjusted at IF (forward current) = 500 mA. There was no significant difference in electrical characteristics between the references and the V chips whose film thicknesses had been adjusted.

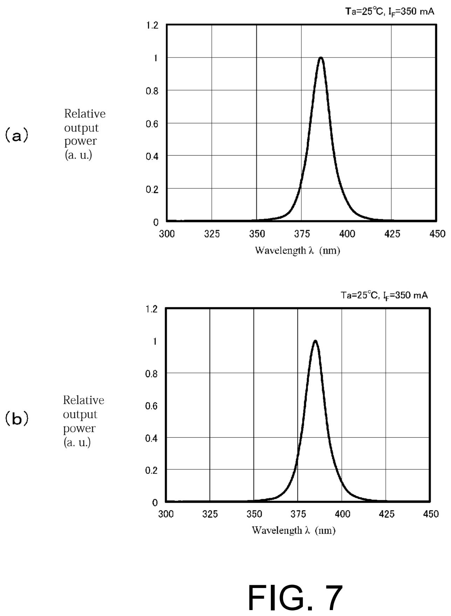

FIG. 7 shows emission spectra of the reference V chips (whose film thicknesses were not adjusted) and the V chips whose film thicknesses had been adjusted. The horizontal axis represents wavelength, and the vertical axis represents relative output power. FIG. 7(a) shows emission spectra of the reference V chips (whose film thicknesses were not adjusted), and FIG. 7(b) shows emission spectra of the V chips whose film thicknesses had been adjusted. There was no significant difference in emission spectrum between the references and the V chips whose film thicknesses had been adjusted.

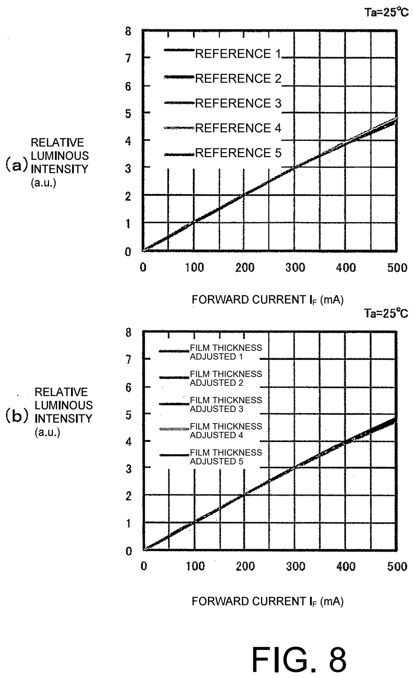

FIG. 8 shows I-L characteristics of the reference V chips (whose film thicknesses were not adjusted) and the V chips whose film thicknesses had been adjusted. The horizontal axis represents IF (forward current), and the vertical axis represents relative luminous intensity. FIG. 8(a) shows I-L characteristics of the reference V chips (whose film thicknesses were not adjusted), and FIG. 8(b) shows I-L characteristics of the V chips whose film thicknesses had been adjusted. There was no significant difference in I-L characteristics between the references and the V chips whose film thicknesses had been adjusted.

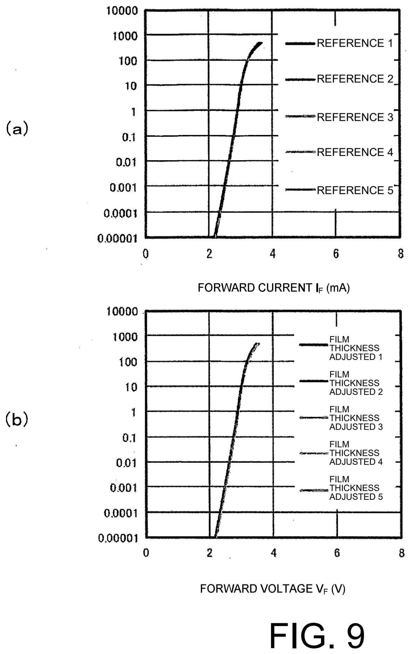

FIG. 9 shows I-V characteristics of the reference V chips (whose film thicknesses were not adjusted) and the V chips whose film thicknesses had been adjusted. The horizontal axis represents VF (forward voltage), and the vertical axis represents IF (forward current). FIG. 9(a) shows I-V characteristics of the reference V chips (whose film thicknesses were not adjusted), and FIG. 9(b) shows I-V characteristics of the V chips whose film thicknesses had been adjusted. There was no significant difference in I-V characteristics between the references and the V chips whose film thicknesses had been adjusted.

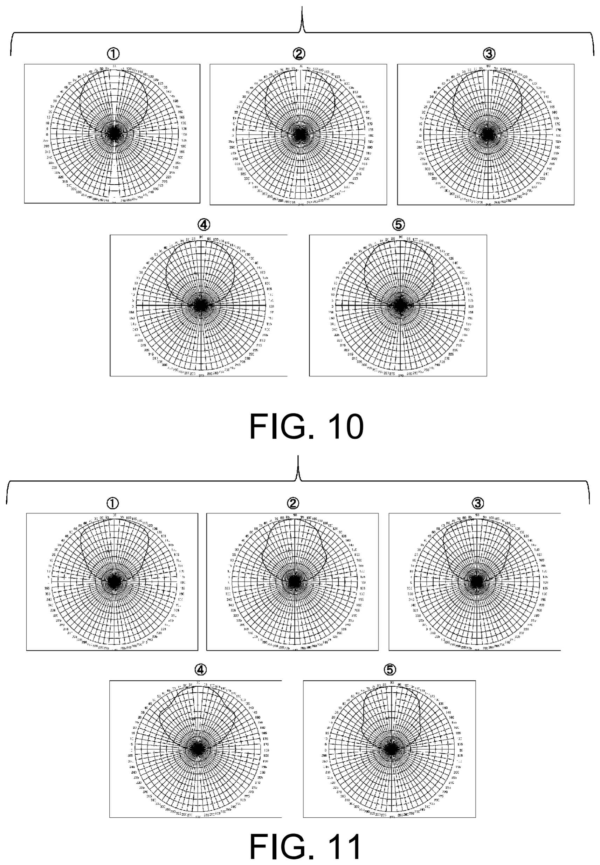

FIGS. 10 and 11 show results of measuring radiation pattern characteristics of the reference V chips (whose film thicknesses were not adjusted) and the V chips whose film thicknesses had been adjusted. In both drawings, the horizontal axis represents relative radiation intensity, and the vertical axis represents relative angle. FIG. 10 shows radiation pattern characteristics of the reference V chips, and the radiation pattern characteristics were similar at a total of five positions indicated by circled numbers 1 to 5.

On the other hand, FIG. 11 shows radiation pattern characteristics of the V chips whose film thicknesses had been adjusted, and the radiation pattern characteristics changed at a total of five positions of circled numbers 1 to 5. When the references and the V chips whose film thicknesses had been adjusted were compared at the same positions on the wafer, it was confirmed that the V chips whose film thicknesses had been adjusted were narrower in radiation pattern.

The reason why the radiation pattern characteristics of the V chips whose film thicknesses have been adjusted are different depending on the positions on the wafer is considered that the film thickness; that is, the resonator length, varies depending on the position on the wafer, and this variation causes a change in radiation pattern characteristic. This means that the radiation pattern characteristic of the V chip can be controlled with high accuracy by suppressing the variation in film thickness and controlling the resonator length with high accuracy.

Furthermore, it was confirmed that the V chip whose film thickness had been adjusted had an output in the range of ±30 degrees directly above the overall output, which was improved by about 7% at the position of the circled number 5 as compared with the reference.

As described above, according to the present embodiment, by adjusting the resonator structure included in the GaN stacked structure constituting the GaN light-emitting element, specifically, the resonator length formed between the surface of the GaN layer and the surface of the metal reflective film below the surface of the GaN layer, the radiation pattern characteristic of light emitted from the GaN light-emitting element can be controlled to a desired characteristic. As a result, the radiation pattern of the light emitted from the GaN light-emitting element can be narrowed, and the output in a certain angular range directly above the overall output can be improved.

REFERENCE SIGNS LIST

| 10 | sapphire substrate |
|----|---------------------|
| 12 | n-GaN layer |
| 14 | MQW layer |
| 16 | p-GaN layer |
| 18 | p-electrode and metal reflective film |
| 20 | metal substrate |
| 22 | support substrate |
| 24 | n-electrode |

**Claims**

1. A method for manufacturing a gallium nitride light-emitting element, the method comprising:

    sequentially stacking a metal reflective film, a p-type gallium nitride layer, a multiple quantum well layer, and an n-type gallium nitride layer on a substrate; and
    adjusting a resonator length formed between a surface of the metal reflective film and a surface of the n-type gallium nitride layer to adjust a radiation pattern characteristic of emitted light.

2. The method according to claim 1, wherein

    in the step of adjusting the resonator length, a film thickness d between the surface of the metal reflective film and the surface of the n-type gallium nitride layer is adjusted such that:

$$d = m \cdot \lambda / n$$

    where n is a refractive index, $\lambda$ is a wavelength of the emitted light, and m is an integer.

3. The method according to claim 2, wherein the emitted light has a narrowed radiation pattern by setting m to have a small value.

4. A method for manufacturing a gallium nitride light-emitting element, the method comprising:

forming an epitaxial structure by epitaxially growing an n-type gallium nitride layer, a multiple quantum well layer, and a p-type gallium nitride layer sequentially on a sapphire substrate;

forming a p-type electrode on the p-type gallium nitride layer;

forming a metal reflective film, a metal substrate, and a support substrate on the p-type electrode;

inverting the epitaxial structure upside down so that the support substrate is located at the bottom and the sapphire substrate is located at the top;

exposing a surface of the n-type gallium nitride layer by peeling off the sapphire substrate located at the top by the inversion;

etching the n-type gallium nitride layer to adjust a resonator length formed between a surface of the metal reflective film and a surface of the n-type gallium nitride layer;

forming an n-type electrode on the n-type gallium nitride layer; and

peeling off the support substrate.

5. The method according to claim 4, wherein

in the etching of the n-type gallium nitride layer, the n-type gallium nitride layer is etched such that:

$$d = m \cdot \lambda / n$$

where d is a film thickness between the surface of the metal reflective film and the surface of the n-type gallium nitride layer, n is a refractive index, $\lambda$ is a wavelength of emitted light, and m is an integer.

6. The method according to any one of claims 1 to 5, wherein the gallium nitride light-emitting element has an emission wavelength of 380 nm to 390 nm.

7. A lighting device comprising:

the gallium nitride light-emitting element manufactured by the method according to any one of claims 1 to 5; and

an illumination optical system that illuminates an object with light from the gallium nitride light-emitting element.

16
14
12
10

FIG. 1A

18
16
14
12
10

FIG. 1B

20
18
16
14
12
10

FIG. 1C

FIG. 1D

FIG. 1E

FIG. 1F

FIG. 1G

FIG. 1H

FIG. 1I

FIG. 2

FIG. 3

(A)

(B)

FIG. 4

FIG. 5

(a)

IF :350mA

| | REFERENCE | | | | | FILM THICKNESS ADJUSTED | | | | |
|---|---|---|---|---|---|---|---|---|---|---|
| | ① | ② | ③ | ④ | ⑤ | ① | ② | ③ | ④ | ⑤ |
| CURRENT [mA] | 350 | 350 | 350 | 350 | 350 | 350 | 350 | 350 | 350 | 350 |
| VOLTAGE [V] | 3.69 | 3.76 | 3.56 | 3.60 | 3.55 | 3.64 | 3.75 | 3.68 | 3.67 | 3.67 |
| TOTAL RADIANT FLUX [mW] | 162.0 | 168.7 | 154.6 | 160.0 | 154.0 | 164.4 | 171.7 | 159.4 | 166.8 | 157.4 |
| PEAK WAVELENGTH [nm] | 385.7 | 387.2 | 385.7 | 385.7 | 385.7 | 384.9 | 387.2 | 384.1 | 385.7 | 384.9 |
| FWHM[nm] | 13.2 | 13.8 | 13.3 | 13.4 | 13.3 | 13.4 | 13.1 | 13.3 | 12.6 | 13.6 |

(b)

IF :500mA

| | REFERENCE | | | | | FILM THICKNESS ADJUSTED | | | | |
|---|---|---|---|---|---|---|---|---|---|---|
| | ① | ② | ③ | ④ | ⑤ | ① | ② | ③ | ④ | ⑤ |
| CURRENT [mA] | 500 | 500 | 500 | 500 | 500 | 500 | 500 | 500 | 500 | 500 |
| VOLTAGE [V] | 3.83 | 3.85 | 3.72 | 3.78 | 3.71 | 3.83 | 3.98 | 3.85 | 3.89 | 3.86 |
| TOTAL RADIANT FLUX [mW] | 226.0 | 234.9 | 213.6 | 219.7 | 212.0 | 226.0 | 237.2 | 220.0 | 231.2 | 215.8 |
| PEAK WAVELENGTH [nm] | 386.5 | 387.2 | 385.7 | 386.5 | 385.7 | 384.9 | 387.2 | 384.9 | 385.7 | 384.9 |
| FWHM[nm] | 13.6 | 14.3 | 13.8 | 13.9 | 13.7 | 13.8 | 13.5 | 13.7 | 13.0 | 14.1 |

FIG. 6

FIG. 7

FIG. 8

FIG. 9

FIG. 10

FIG. 11

# EP 4 723 178 A1

## INTERNATIONAL SEARCH REPORT

| | | International application No. |
|---|---|---|
| | | **PCT/JP2024/019565** |

**A.  CLASSIFICATION OF SUBJECT MATTER**

*H01L 33/46*(2010.01)i; *G03F 7/20*(2006.01)i; *H01L 33/32*(2010.01)i
FI:  H01L33/46; H01L33/32; G03F7/20 501; G03F7/20 521

According to International Patent Classification (IPC) or to both national classification and IPC

**B.  FIELDS SEARCHED**

Minimum documentation searched (classification system followed by classification symbols)

H01L33/46; G03F7/20; H01L33/32

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C.  DOCUMENTS CONSIDERED TO BE RELEVANT**

| Category* | Citation of document, with indication, where appropriate, of the relevant passages | Relevant to claim No. |
|---|---|---|
| A | JP 2014-75569 A (SHOWA DENKO KK) 24 April 2014 (2014-04-24) | 1-7 |
| A | JP 2014-86533 A (SHOWA DENKO KK) 12 May 2014 (2014-05-12) | 1-7 |
| A | JP 2008-16836 A (SAMSUNG ELECTRO MECH. CO., LTD.) 24 January 2008 (2008-01-24) | 1-7 |
| A | JP 2013-162057 A (STANLEY ELECTRIC CO., LTD.) 19 August 2013 (2013-08-19) | 1-7 |
| A | WO 2021/208824 A1 (RAYSOLVE OPTOELECTRONICS (SUZHOU) CO., LTD.) 21 October 2021 (2021-10-21) | 1-7 |

☐ Further documents are listed in the continuation of Box C.    ☑ See patent family annex.

| | |
|---|---|
| \*  Special categories of cited documents:<br>"A"  document defining the general state of the art which is not considered to be of particular relevance<br>"D"  document cited by the applicant in the international application<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
|---|---|
| **12 June 2024** | **25 June 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT
### Information on patent family members

International application No.

**PCT/JP2024/019565**

| Patent document cited in search report | | | Publication date (day/month/year) | Patent family member(s) | | | Publication date (day/month/year) |
|---|---|---|---|---|---|---|---|
| JP | 2014-75569 | A | 24 April 2014 | (Family: none) | | | |
| JP | 2014-86533 | A | 12 May 2014 | (Family: none) | | | |
| JP | 2008-16836 | A | 24 January 2008 | US | 2008/0012028 | A1 | |
| | | | | KR | 10-2008-0003486 | A | |
| JP | 2013-162057 | A | 19 August 2013 | (Family: none) | | | |
| WO | 2021/208824 | A1 | 21 October 2021 | US | 2021/0320229 | A1 | |
| | | | | KR | 10-2022-0139995 | A | |
| | | | | CN | 113193091 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004111766 A

- JP 2011054828 A